# EUROPÄISCHE PATENTSCHRIFT

(11) **EP 1 560 273 B1**
(45) Veröffentlichungstag und Bekanntmachung des Hinweises auf die Patenterteilung: **06.07.2011**
(21) Anmeldenummer: 03774413.3
(22) Anmeldetag: 23.10.2003
(51) Int. Cl.: C09K 11/08, C09K 11/77, H05B 33/14, H01L 33/50

(54) **HALBLEITER-WEISSLICHTQUELLE**
SEMICONDUCTOR WHITE LIGHT SOURCE
SOURCE SEMI-CONDUCTRICE DE LUMIERE BLANCHE

(30) Priorität: 25.10.2002 RU 2002129264
(43) Veröffentlichungstag der Anmeldung: 03.08.2005
(73) Patentinhaber: "Svetlana-Optoelektronika", St. Petersburg, 194156 (RU)
(72) Erfinder: ITKINSON, Grigory Vladimirovich, St. Petersburg, 197119 (RU); ZAKGEIM, Aleksandr Lvovich, St. Petersburg, 197371 (RU); VASILIEVA, Elena Dmitrievna, St. Petersburg, 197371 (RU); CHERNOVETS, Boris Vasilievich, St. Petersburg, 193015 (RU); GREKOV, Fedor Fedorovich, St. Petersburg, 194358 (RU); BOGDANOV, Aleksandr Aleksandrovich, St. Petersburg, 198303 (RU)
(74) Vertreter: Jeck, Anton
(86) Internationale Anmeldenummer: PCT/RU2003/000472
(87) Internationale Veröffentlichungsnummer: WO 2004/038815

(56) Entgegenhaltungen:
- WO-A2-01/50500
- GB-A- 2 373 368
- RU-C1- 2 170 995
- US-A- 5 998 925
- US-A- 5 998 925
- KREVEL VAN J W H ET AL: "LUMINESCENCE PROPERTIES OF TERBIUM-, CERIUM-, OR EUROPIUM-DOPED ALPHA-SIALON MATERIALS" JOURNAL OF SOLID STATE CHEMISTRY, ORLANDO, FL, US, Bd. 165, Nr. 1, 1. April 2002 (2002-04-01), Seiten 19-24, XP001157540 ISSN: 0022-4596

## Beschreibung

Die Erfindung bezieht sich auf die Optoelektronik, und zwar auf Konstruktionen von Halbleiterquellen für die Ausstrahlung von Weißlicht.

### Stand der Technik

Halbleitergeräte, die Weißlicht ausstrahlen, sind vom Standpunkt ihrer Nutzung als wirtschaftliche und sichere Lichtquellen sehr bedeutungsvoll und können die traditionellen Glühlampen und Kaltlichtlampen in Beleuchtungssystemen ersetzen.

Es sind Konstruktionen mit LEDs bekannt, zum Beispiel durch den Artikel von S. Nakamura, G. FasoL "The blue laser diode", Kapitel 10.4 "White LEDs", S. 343, Springer-Verlag, Berlin 1997, US-Patent 5962971, veröffentlicht 2001, die einen Halbleiter-Elektrolumineszenzkristall, der das Licht im blauen Spektralbereich ausstrahlt, und eine auf dem Kristall aufgetragene Beschichtung aus Fotoluminiszenzmaterial aufweisen, dessen Anregungsspektrum mit dem Strahlungsspektrum des Kristalls abgestimmt ist. Dabei strahlt das Fotolumineszenzmaterial gelbes Licht aus, das bei der Vermischung mit dem vom Kristall ausgestrahlten Licht Weißlicht ergibt.

Das beschriebene Prinzip der Gewinnung von Weißlicht liegt der vorliegenden Konstruktion der Halbleiterquelle für Weißlicht zugrunde (US 5998925, veröffentlicht 1999).

Die erwähnte Lichtquelle enthält einen Halbleiter-Elektrolumineszenzkristall auf der Basis eines Mehrelementen-Systems AL-In-Ga-N, das Licht im violett-blauen Spektralbereich erzeugt, und eine Beschichtung, die einen Leuchtstoff enthält, für das Aluminiuum-Yttrium-Granat verwendet wird, das durch Zer aktiviert ist.

Der in der erwähnten Konstruktion verwendete Leuchtstoff hat im blau-violetten Spektralbereich ein verhältnismäßig enges Anregungsspektrum mit einem Maximum bei einer Wellenlänge von 470 nm, während die AL-In-Ga-N-Kristalle eine bemerkenswerte Streuung abhängig von den Längen der Erzeugungswellen haben. Dabei verfügen die Kristalle über eine maximale Effektivität im kurzwelligen Bereich von 400-450 nm, wodurch der Lichtwirkungsgrad der zu betrachtenden Halbleiterlichtquelle verringert wird.

Außerdem verfügt der in dieser Konstruktion verwendete Leuchtstoff über eine verhältnismäßig niedrige Temperatur zum Löschen der Lumineszenz.

Es ist ferner bekannt durch EU-aktiviertes α-Sialon-Material als Leuchtstoff zur Erzeugung von weißem Licht zu verwenden, wobei eine sehr effiziente Lumineszenz erreicht wird (Krevel van J W H et Al "Luminescence Properties of Terbium-, Cerium-, Or Europhium-doped Alpha-Sialon Materials" Journal of solid state chemistry, Orlando, FI, US, Bd. 165, Nr. 1, 1. April 2002 (2002-04-01), Seiten 19 - 24, XP001157540 ISSN: 0022-4596).

### Kurzfassung der Erfindung

Es ist Aufgabe der Erfindung, auf der Basis von AL-In-Ga-N-Strahlungskristallen unter Verwendung der bekannten Zusammensetzungen eine Halbleiterquelle für Weißlicht zu schaffen, die eine hohe optische Effektivität und Stabilität der Parameter verfügt.

Die gestellte Aufgabe wird nach der Erfindung dadurch gelöst, dass der Leuchtstoff zusätzlich Fluor in einem Anteil von 1 - 25 % at im Verhältnis zum Gesamtgehalt von Stickstoff, Sauerstoff und Fluor im Oxonitrid-α-Sialvnmaterial enthält.

Die Einführung von Fluor in den Leuchtstoff vereinfacht die Valenzabstimmung der Elemente der Leuchtstoffe. Gleichzeitig erhöht die Fluoreinführung in die Matrix die Ionengehaltstufe der Bindungen rings um das Europium-Atom, was eine hohe Zunahme der Lumineszenzeffektivität zur Folge hat.

Bei der Lichtquelle gemäß der Erfindung wird ein Strahlungskristall auf der Basis des Mehrelementen-Systems Al-In-Ga verwendet, der je nach dem Gehalt an In und Ga im aktiven Bereich ein solches Licht austrahlt, das dem echten (gesättigten) violetten, blauen oder hellblauen Licht nahe liegt (die Halbbreite der spektralen Linie beträgt ca. 15 - 20 nm, und die Lage des Maximums variiert im Bereich einer Wellenlänge von 400 - 470 nm.

Das für de Realisierung der Erfindung erforderliche gelbe Licht der Lumineszenz als Zusatz zum violett-blauen Licht wird durch die zentrumsintemen Übergänge der Atome vom zweiwertigen Europium gewährleistet, das in die Teilchen des Leuchtstoffs eingeführt ist, dessen Grundlage ein Oxinitrid-α-Sialon-Material bildet.

Die Oxinitrid- α-Sialon-Materialien gehören zu der umfangreichen Gruppe der Sia-Ionmaterialien und stellen Oxonitrid-Phasen von variablen Zusammensetzungen dar (feste Lösungen), die Silizium (Si), Aluminium (Al), Sauerstoff (O), Stickstoff (N) enthalten (R. A. Andriyewskiy, I. I. Spivak, "Siliziumnitrid und die Materialien auf seiner Grundlage", M: Verlag Metallurgie, 1984, Seiten 5-15). Zur Zusammensetzung von Sialon können außer den erwähnten vier Elementen auch andere Elemente gehören. Insbesondere kann Silizium teilweise durch Germanium ersetzt werden, und Aluminium kann durch Gallium teilweise ersetzt werden. Außerdem können zur Zusammensetzung von Sialon alkalische Metalle und Erdalkalimetalle, wie Lithium, Natrium, Kalium, Rubidium, Zäsium, Berylium, Magnesium, Kalzium, Strontium und Barium, gehören.

Bei der vorliegenden Erfindung wird als Grundlage für den Leuchtstoff Oxinitrid- α-Sialon-Material verwendet, das unabhänig von der konkreten Zusammensetzung in struktureller Hinsicht α-Siliziumnitrid wiedergibt, dessen Karkassematrix (und dementsprechend die Karkassematrix von Oxinitrid-α-Sialon) Höhlen besitzt, die nach den Ausmaßen und der Koordination mit den Atomen des Aktivators des Leuchtstoffs abgestimmt sind, wobei als Aktivator zweiwertiges Europium ausgewählt ist.

Insbesondere kann als Leuchtstoff bei der Halbleiterlichtquelle gemäß der Erfindung durch zweiwertiges Europium aktiviertes Oxinitrid-α-Sialon-Material verwendet werden, dessen Zusammensetzung im Bereich von 0,25% Eu, 10% Si, 2,0% Al, 1,75% O bis 15,25% N liegen kann. Die maximale Effektivität der Fotolumineszenz wurde bei einer Zusammensetzung des Leuchtstoffs von 0,5% Eu, 7,5% Si, 4,5% Al, 3,5% O und 12,5% N erreicht.

Wie von den Erfindern durchgeführte Untersuchungen zeigten, besitzt das als Leuchtstoff ausgewählte, durch zweiwertiges Europium aktivierte Oxinitrid-α-Sialon-Material ein breites Anregungsspektrum im Bereich der Wellenlängen von 400-470nm, der das Gebiet des Auftretens von Maxima der typischen Strahlungsspektren der Kristalle auf der Basis von Al-In-Ga-H überdeckt. Dabei strahlt der Leuchtstoff Licht im Bereich der Wellenlangen von 560-580nm ab, der dem gelben Spektralbereich entspricht, der in der Kombination mit dem vom Kristall ausgestrahlten Licht weißes Licht ergibt.

Die Fähigkeit der Oxinitrid-α-Sialonmatrix zu heterovalenten Ersetzungen erlaubt neben dem Europium in den Leuchtstoff ein oder mehrere Elemente aus der Gruppe Ce, Pr, Nd, Sm, Gd, Tb, Dy, Ho, Er, Tm, Yb, Mn, Ti, Cr, Sn oder deren Verbindungen aufzunehmen. Die Einführung der erwähnten Elemente erlaubt, die Frequenzcharakteristiken der Anregungsspektren und der Ausstrahlungen des Leuchtstoffs zu verwalten. Dies wird dadurch erreicht, dass die Atome der erwähnten Elemente, indem sie die anregende Ausstrahlung absorbieren, nicht nur das Strahlungsspektrum ergänzen, sondern auch die Energie den benachbarten Atomstrahlem (hauptsächlich Europium) übergeben können, d.h., dass ein Sensibilisierungseffekt realisiert werden kann.

Die summarische Menge an Europium und an zusätzlich aufgenommenen Elementen, bei der (registriert beim Versuch) ein wesentlicher Lumineszenzeffekt erreicht wird, beträgt mindestens 0,3% at. Die maximal mögliche, summarische Menge an Europium und an zusätzlich aufgenommenen Elementen wird von dem natürlich möglichen Auffüllungsgrad der Matrixhöhlen durch den als Grundlage ausgewählten Leuchtstoff des konkreten Oxinitrid-α-Sialon-Materials begrenzt.

Die Einmischung von Fluor in den Leuchtstoff vereinfacht die Abstimmung der Valenzen der Elemente, die zur Zusammensetzung des Leuchtstoffs gehören, und erhöht gleichzeitig den lonengehalt der Karkassematrix, wodurch die Lumineszenzeffektivität positiv beeinflusst wird. Die Grenzwerte des Gehalts an Fluor im Leuchtstoff beträgt von 1-25% at vom gesamten Gehalt an Sauerstoff, Stickstoff und Fluor im Leuchtstoff. Damit die oben genannten Effekte auftreten können, soll die Menge an Fluor mindestens 1 % at sein. Bei einer Menge an Fluor von mehr als 25% at geht die Standfestigkeit der Karkassenstruktur des Leuchtstoffs verloren.

Der Leuchtstoff kann insbesondere mit dem Verfahren der gemeinsamen hydrolytischen Sedimentation mittels einer konzentrierten Lösung von Ammoniak der hochaktiven Oxid-Mischung jener Metalle, die als Bestandteile der Grundlage des Kationteils der zu synthetisierenden α-Sialon-Matrix ausgewählt sind, aus den jeweiligen elementorganischen Verbindungen oder unorganischen Salzen gewonnen werden. Zur Einführung von Europium und anderen zusätzlichen Elementen in den Leuchtstoff wird die ausgetrocknete Mischung der gewonnenen Oxide mit Europiumoxid oder Europiumfluorid sowie mit dem Oxid (Oxiden) oder dem Fluorid (Fluoriden) des jeweiligen Elements (Elemente) gemischt, wobei das Verfahren des Nassmahlens in einem Medium aus Isopropylalkohol eingesetzt wird. Dann wird die Mischung einem gestuften Glühen in einer Ammoniak-Atmosphäre unterzogen, wobei der Dissoziationsgrad im Reaktor kontrolliert wird. In der Schlussphase der Synthese wird das homogenisierende Glühen des Produkts in einer Stickstoff-Atmosphäre bei einer Temperatur von mehr als 1500°C durchgeführt. Das Ausmaß der Teilchen des zu gewinnenden Leuchtstoffs variiert im Bereich von 5-25 mkm.

Bei der Halbleiterlichtquelle gemäß der Erfindung kann die Beschichtung, die den Leuchtstoff enthält, als ein den Strahlungskristall deckenden Immersionsmedium ausgeführt sein, das die in einer Epoxid-Zusammensetzung verteilten Teilchen des durch das zweiwertige Europium aktivierten Oxonitrid-α-Sialon-Materials darstellt. Der Gehalt an Leuchtstoff in der Zusammensetzung kann in einem großen Bereich variieren und normalerweise von 30-60 Gew.% betragen.

### Kurzbeschreibung der Zeichnungen

Die vorliegende Erfindung wird nun anhand von Ausführungsbeispielen näher erläutert. Es zeigen:

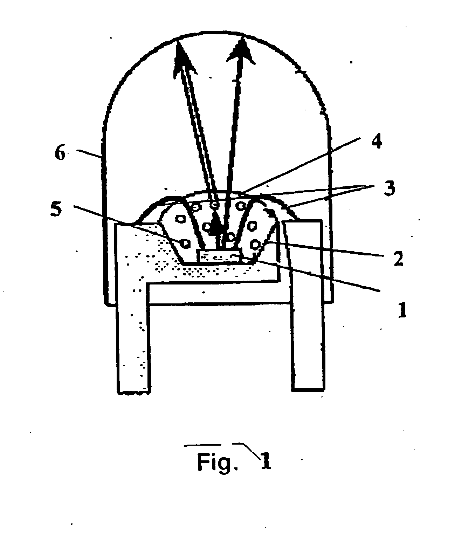

- Fig.1: einen Schnitt durch eine Halbleiterquelle für Weißlicht gemäß der Erfindung,
- Fig. 2: eine Darstellung des Anregungsspektrums eines Leuchtstoffs aus 0,5% Eu, 7,5% Si, 4,5% Al, 3,5% O, 12,5% N (weiter SiAION:Eu), eine Darstellung des Anregungsspektrums eines Leuchtstoffs aus Aluminium- Yttrium-Granat der Marke PTCW01-B, das durch Zer aktiviert ist, Produktion "Phosphor Tech", USA (weiter YAG:Ce) und eine Darstellung der Arten der typischen Strahlungsspektren der Strahlungskristalle auf der Basis des Systems Al-ln-Ga-N mit einem unterschiedlichen Gehalt an In und Ga im aktiven Bereich,
- Fig. 3: eine Darstellung der Abhängigkeiten des Quantenausgangs der Aus- strahlung des Leuchtstoffe SiAlON:Eu und YAG:Ce von der Wellenlänge der anregenden Strahlung,
- Fig. 4: eine Darstellung der Spektren der Fotolumineszenz für die Leuchtstoffe SiAlON:Eu und YAG:Ce,
- Figuren 5 und 6: Darstellungen der Ergebnisse der Untersuchungen der Temperaturstabilität für die Lichtquelle mit dem Leuchtstoff SiAlON:Eu,
- Figuren 7 und 8: Darstellungen der Ergebnisse der Untersuchungen der Temperaturstabilität für die Lichtquelle mit dem Leuchtstoff YAG:Ce,
- Figuren 9 und 10: Darstellungen des Abbaus der Spektralcharakteristiken in Abhängigkeit von der Zeit der Nutzungsdauer der Lichtquelle mit dem Leuchtstoff SiAlON:Eu und der Lichtquelle mit dem Leuchtstoff YAG:Ce.

### Bestes Ausführungsbeispiel

Eine Quelle für Weißlicht enthält einen Halbleiter-Strahlungs-Kristall 1 aus Al-In-Ga-N, der in einem Mikroreflektor 2 montiert ist. Der Kristall 1 ist mit Eingängen 3 für das Heranführen der Stromversorgung ausgestattet. Der Kristall 1 weist eine Beschichtung auf, die einen Leuchtstoff enthält. Die Beschichtung ist ein den Mikroreflektor 2 füllendes Immersionsmedium und stellt in einer Epoxid-Zusammensetzung 4 verteilte Teilchen 5 des Leuchtstoffs dar. Als Leuchtstoff wurde ein durch zweiwertiges Europium aktiviertes α-Sialon-Material verwendet. Zur Abdichtung der Lichtquelle und zur Bildung einer Strahlungsindikatrix wird darauf eine Linse 6 aus einer durchsichtigen Epoxid-Zusammensetzung aufgeklebt.

Diese Halbleiterquelle arbeitet auf folgende Weise.

Der Kristall 1 wird mit Hilfe der Eingänge 3 an die Stromversorgungsquelle (auf der Zeichnung nicht gezeigt) angeschlossen; dabei beginnt er, Licht im blau-violetten Spektralbereich auszustrahlen. Die Teilchen 5 des Leuchtstoffs, die in der Epoxid-Zusammensetzung 4 verteilt sind, absorbieren einen Teil der Strahlung des Kristalls 1 und strahlen das Licht im gelben Spektralbereich aus. Die beiden Strahlungen ergeben die weiße Farbe, wobei sie in einem Verhältnis gemischt werden, die von der Stärke der Leuchtstoffbeschichtung und der Konzentration der darin enthaltenen Teilchen bestimmt wird.

Es wurden der Leuchtstoff, dessen Zusammensetzung der Formel Eu _{0,5}, Si _{7,5}, AL _{4,5}, O _{3,5}, N_{12,5} (SiAlON:Eu) entsprach, und die Lichtquelle getestet, in der der Al-In-Ga-N-Kristall verwendet wurde, der mit dem Verfahren der Gasphasenepitaxie aus metallorganischen Verbindungen A1, 1a und Ga in Anwesenheit von Ammoniak gewonnen wurde, mit quantenmetrischer Heterostruktur, die die Zusammensetzung des aktiven Bereichs In_{0.2}Ga_{0.8}N sowie eine Beschichtung hat, die den oben genannten Leuchtstoff enthält. Zum Vergleich wurden der auf dem Markt vorhandene Leuchtstoff aus Aluminium-Yttrium-Granat der Marke PTCW01-B, der mit Zer aktiviert wurde, Produktion "Phosphor Tech", USA (YAG:Ce), und die Lichtquelle getestet, in der der Al-ln-Ga-N-Kristall mit den gleichen Spektralcharakteristiken, die auch bei dem Kristall in der Lichtquelle gemäß der Erfindung vorhanden sind, und die Beschichtung, die den Leuchtstoff YAG:Ce enthält, verwendet wurde

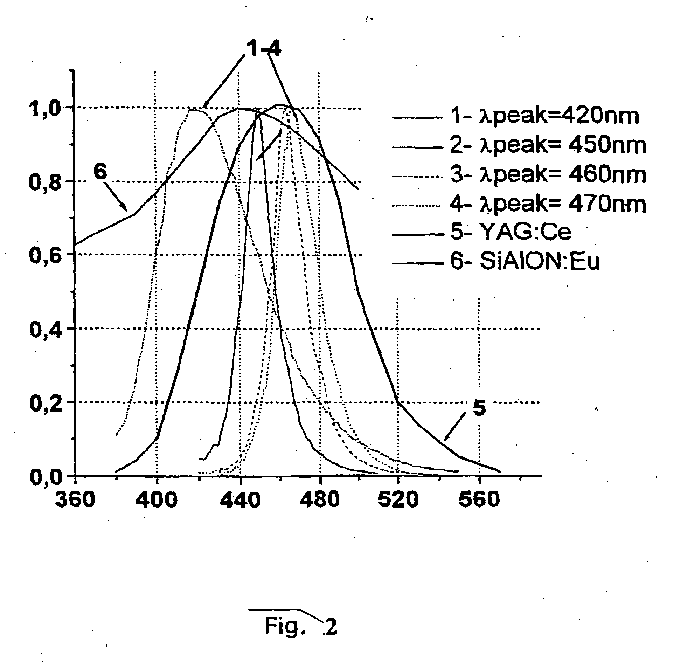

Es wurden die Anregungsspektren der Leuchtstoffe SiAlON:Eu und YAG:Ce untersucht. In Fig. 2 sind (in relativen Einheiten) die Abhängigkeiten der Intensitäten der Anregungsspektren der Leuchtstoffe SiAl0N:Eu (Kurve 6) und YAG:Ce (Kurve 5) von der Wellenlänge sowie (in relativen Einheiten) die Abhängigkeiten der Intensivitäten der Strahlungsspektren der Kristalle auf der Basis des Systems Al-In-Ga-N mit einem unterschiedlichen Gehalt an In und Ga im aktiven Bereich (Kurven 1-4) von der Wellenlänge dargestellt.

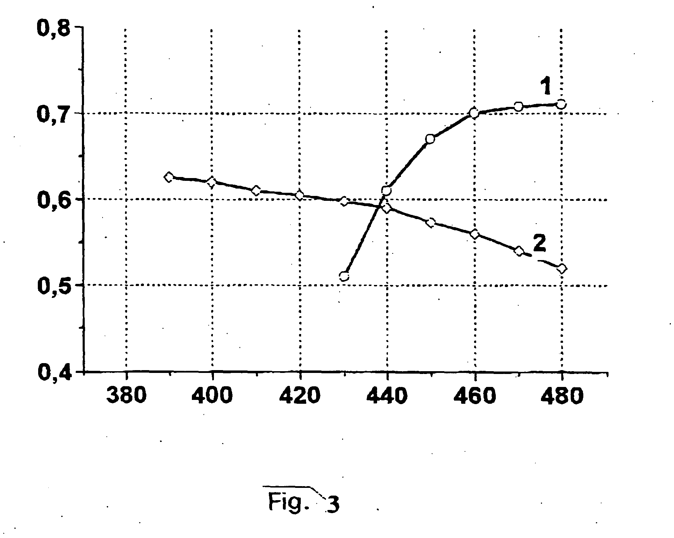

Es wurde der Quantenausgang der Strahlung der Leuchtstoffe SiAlON:Eu und YAG:Ce untersucht. In Fig. 3 sind die Abhängigkeiten des Quantenausgangs der Ausstrahlung der Leuchtstoffe SiAlON:Eu (Kurve 2) und YAG:Ce (Kurve 1) von der Wellenlänge der anregenden Ausstrahlung dargestellt.

Wie sich aus den grafischen Darstellungen in den Figuren 2 und 3 erkennen lässt, hat der Leuchtstoff SiAlON:Eu ein breites Anregungsspektrum, das den ganzen Bereich der Wellenlängen von 400 bis 480nm überdeckt, in dem sich die Maxima der typischen Strahlungsspektren der Kristalle auf der Basis des Systems Al-In-Ga-N befinden, und eine fast flache, zum kurzwelligen Rand etwas steigende Abhängigkeit von der Wellenlänge des Quantenausgangs der Ausstrahlung im zu betrachtenden Bereich der Wellenlängen. Gleichzeitig zeichnet sich der Leuchtstoff YAG:Ce durch die glockenartige Form der Kurve des Anregungsspektrums aus, die fast bis auf Null am kurzwelligen Rand des Wellenlängenbereichs von 400-480nm abfällt. Dementsprechend zeigt die Kurve des Quantenausgangs des Leuchtstoffs YAG:Ce einen erheblichen Rückgang bei den Wellenlängen, die weniger als 440nm betragen.

Daraus lässt sich schlussfolgem, dass der Leuchtstoff SiAlON:EU durch die Übereinstimmung des Anregungsspektrums mit den Strahlungsspektren (Pumpen) der Kristalle auf der Basis des Systems Al-In-Ga-N durch einen breiten Bereich der Wellenlängen charakterisiert ist, so dass der Umfang der zur Nutzung für die Lichtquelle gemäß der Erfindung geeigneten Kristalle erweitert wird.

Der Leuchtstoff SiAlON:EU ist auch durch eine hohe Quanteneffektivität der Umgestaltung der Pumpen-Ausstrahlung in die Lumineszenzausstrahlung charakterisiert. Es ist in diesem Zusammenhang besonders aktuell, dass sich, wie die letzten experimentalen Untersuchungen von T. Mukai, "Recent Progress in Group-III Nitride Light-emitting Diodes", IEEE J. on selected topic of quantum electronics, V. 6, Nr. 2, 2002, Seite 264, zeigen, der maximale äußere Quantenausgang (maximale Effektivität) der Al-bi-Ga-N-LEDs im kurzwelligen Bereich (λ=400-440nm) des zu betrachtenden Bereichs der Wellenlängen beobachten lässt.

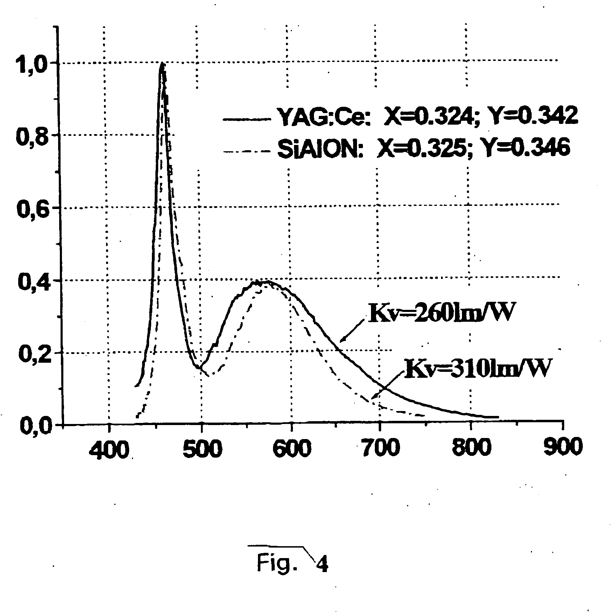

Es wurden die Spektren der Fotolumineszenz der Leuchtstoffe SiAlON:Eu und YAG:Ce bei der Anregung durch die Pumpen-Ausstrahlung λₘₐₓ=470nm untersucht. In Fig. 4 sind (in relativen Einheiten) die Abhängigkeiten der Intensitäten der Strahlungsspektren für die Leuchtstoffe SiAION:Eu (punktierte Linie) und YAG:Ce (Volllinie) von der Wellenlänge gezeigt

Wie aus den Kurven hervorgeht, haben beide Leuchtstoffe die gleiche, dominante Wellenlänge der Ausstrahlung λ_{dom}=574nm, was erlaubt, bei der Vermischung mit der Pumpen-Ausstrahlung für jeden der Leuchtstoffe weißes Licht zu erhalten, das dem "idealen" Weißlicht nahe kommt (für den Leuchtstoff SiAlON:Eu sind die Farbenkoordinaten x=0,325 und y=0,346; für den Leuchtstoff YAG:Ce sind die Farbenkoordinaten x=0,324 und y=0,342). Jedoch gilt als wichtiger Vorteil des Leuchtstoffs SiAl0N:Eu die Abwesenheit eines "Langweiten-Schwanzes" in seinem Fotolumineszenzspektrum, der außerhalb des vom menschlichen Auge wahrnehmbaren Spektralbereichs liegt, was sich auf seine Lichteffektivität auswirkt (die Lichteffektivität für den Leuchtstoff SiA10N:Eu beträgt Kv=310 Im/W, für den Leuchtstoff YAG:Ce Kv=260 Im/W).

Es wurde die Veränderung in Abhängigkeit von der Umgebungstemperatur der Spektralcharakteristiken der Lichtquelle mit der Pumpen-Ausstrahlung λₘₐₓ=470nm jedes Leuchtstoffs SiAlON:Eu bzw. YAG:Ce untersucht.

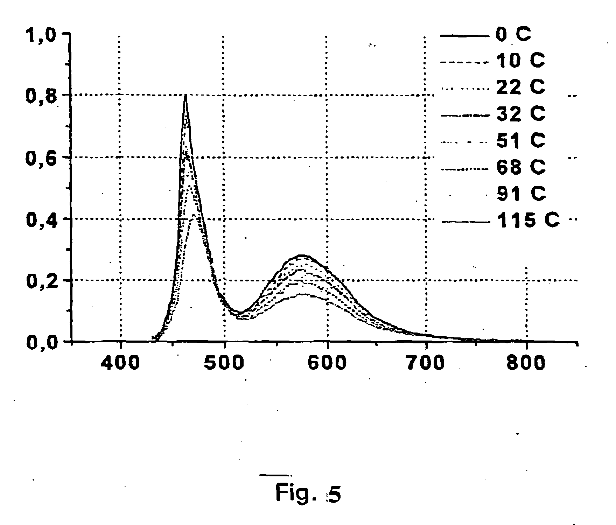

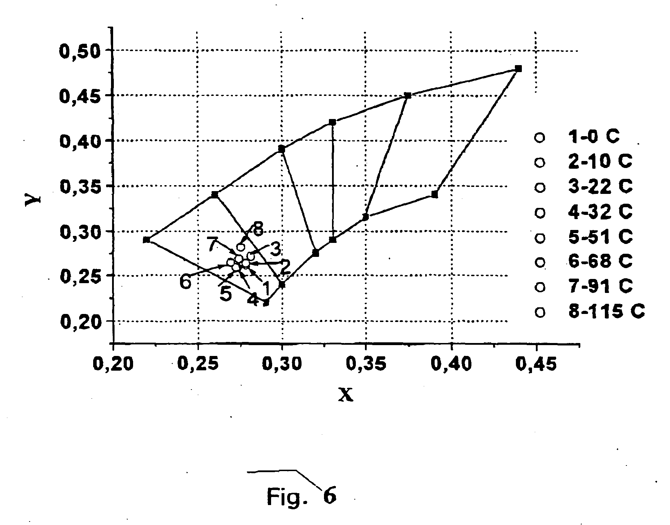

In Fig. 5 ist (in relativen Einheiten) die Abhängigkeit von der Wellenlänge der Strahlungsspektren der Lichtquellen mit dem Leuchtstoff SiAlON:Eu bei unterschiedlichen Temperaturen im Bereich von 0 bis 115°C dargestellt, während in Fig. 6 die den erwähnten Strahlungsspektren entsprechende Position der Farbigkeitskoordinaten auf dem Farbendiagramm dargestellt ist.

Wie aus den Kurven in Fig. 5 zu erkennen ist, bleibt bei der Veränderung der Temperatur das Verhältnis der blauen und gelben Streifen in den Strahlungsspektren der Lichtquelle praktisch konstant (es gibt keinen Löscheffekt der Fotolumineszenz) und dementsprechend, wie sich aus der Zeichnung in Fig. 6 erkennen lässt, ändem sich die Farbigkeitskoordinaten der Ausstrahlung kaum mit der Temperatur, wobei sie innerhalb einer und derselben Tönung der weißen Farbe bleiben.

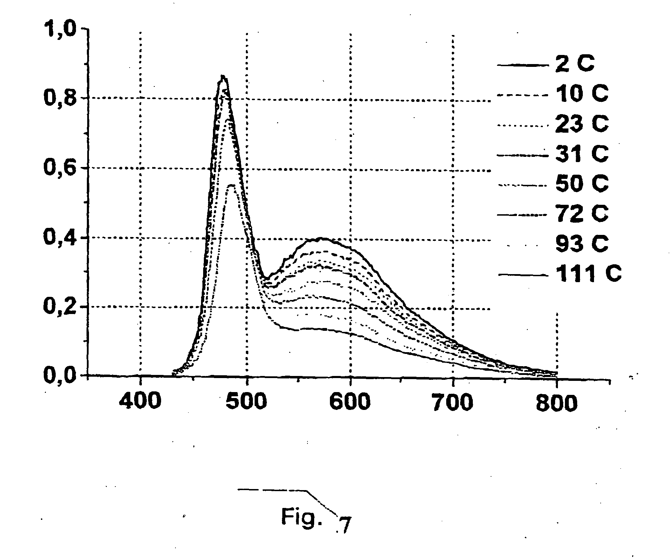

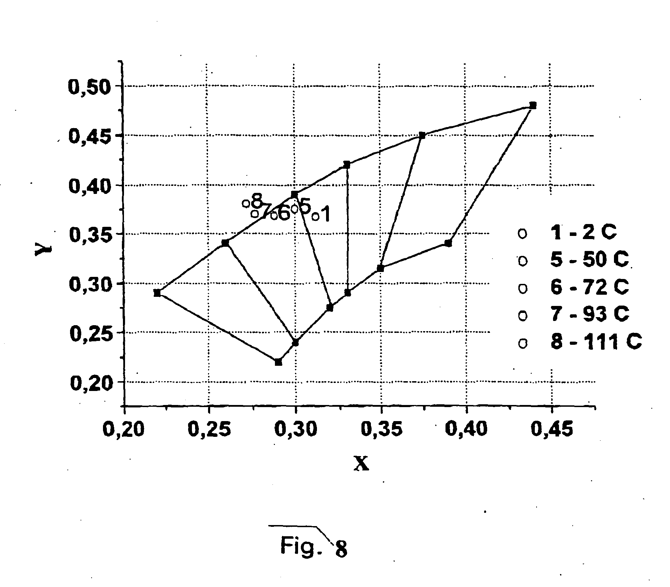

In den Figuren 7 und 8 sind die Ergebnisse der gleichen Untersuchungen der Temperaturstabilität für die Lichtquelle mit dem Leuchtstoff YAG:Ce (im Temperatur bereich von 0 bis 111 °C) dargestellt.

Wie sich aus den Kurven in diesen Figuren erkennen lässt, erfolgt ab der Temperatur von 50°C ein bemerkenswertes Löschen der Fotolumineszenz, das zur Veränderung der Farbigkeitskoordinaten der Ausstrahlung der Lichtquelle und zu einer Abstrahlung außerhalb der Bereichs der weißen Farbe (Fig. 8) führt.

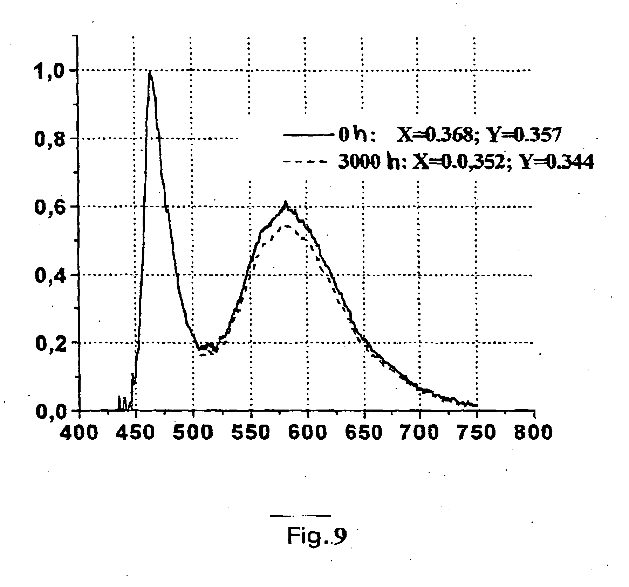

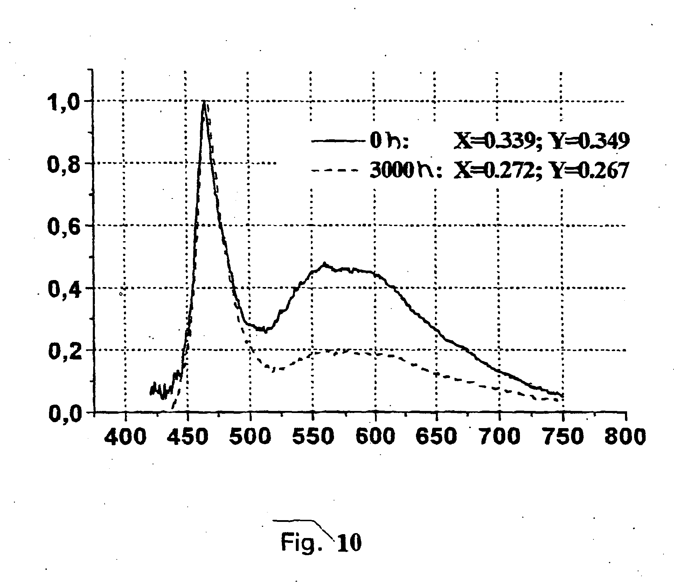

Ferner wurde der Leistungsabfall der Spektralcharakteristiken abhängig von der Zeit der Nutzungsdauer der Lichtquelle mit dem Leuchtstoff SiAlON:Eu (Fig. 9) und der Lichtquelle mit dem Leuchtstoff YAG:Ce (Fig. 10) untersucht. In den Figuren 9 und 10 sind mit der Volllinie (in relativen Einheiten) die Abhängigkeiten von der Wellenlänge der Intensitäten der Strahlungsspektren der entsprechenden Lichtquellen im Anfangsmoment der Zeit und mit der gestrichelten Linie die betreffende Abhängigkeiten nach der Nutzungsdauer von 3000 Stunden gezeigt, wobei die Umgebungstemperatur 60°C und der Speisegleichstrom 20mmA betrug.

Wie sich aus Fig. 9 erkennen lasst, erfolgt abhängig von der Zeit keine bemerkenswerte Veränderung der Spektralcharakteristik der Lichtquelle mit dem Leuchtstoff SiAlON:Eu, während nach Fig. 10 die Spektralcharakteristik der Lichtquelle mit dem Leuchtstoff YAG:Ce abhängig von der Zeit eine Verschiebung der Farbe in den blauen Bereich zeigt.

Wie Untersuchungen gezeigt haben, verfügt die neue, von den Erfindern entwickelte Halbleiterquelle für Weißlicht, die einen Kristall auf der Basis des Systems Al-ln-Ga-N und eine Beschichtung, die den Leuchtstoff Oxinitrid-α-Sialon aufweist, der durch zweiwertiges Europium aktiviert ist, über eine hohe optische Effektivität.

Außerdem verfügt die Lichtquelle gemäß der Erfindung über eine hohe Temperatur- und Zeit-Stabilität der Parameter.

### Industrielle Anwendbarkeit

Die vorliegende Erfindung kann eine breite Anwendung in verschiedenen Wirtschaftszweigen finden. Die vorgeschlagenen Halbleiterquellen für Weißlicht können als Elemente von Leuchteinrichtungen, insbesondere in Systemen mit LEDs, beispielsweise für lichtoptische Eisenbahnampeln, als Signallichter im Rettungswesten, für das Ausleuchten von konstruktiven Elementen bei Möbeln, für die Beleuchtung von Werbeschildem und von Werbeflächen verwendet werden.

Besonders bedeutungsvoll ist die Nutzung der vorliegenden Erfindung in Lichteinrichtungen, die für die Straßenbeleuchtung und der Beleuchtung von Räumen vorgesehen sind. Die Halbleiterquelle für Weißlicht gemäß der Erfindung wurde im Forschungslaboratorium für optische Messungen ZAO "Swetlana-Optoelektronik" erprobt und hat eine hohe optische Effektivität gezeigt.

## Patentansprüche

1. Halbleiterquelle für Weißlicht, die einen Halbleiter-Strahlungskristall (1) auf der Basis eines Mehrelementensystems Al-In-Ga-N, das Licht im violett-blauen Spektralbereich erzeugt, und eine Beschichtung aufweist, die einen Leuchtstoff (5) enthält, der einen Teil des vom Kristall (1) ausgestrahlten Lichts absorbiert und Licht im gelben Spektralbereich abstrahlt, wobei als Leuchtstoff (5) durch zweiwertiges Europium aktiviertes α-Sialonmaterial verwendet wird und wobei der Leuchtstoff (5) zusätzlich ein Element oder mehrere Elemente aus der Gruppe Ce, Pr, Nd, Sm, Gd, Tb, Dy, Ho, Er, Tm, Yb, Mn, Ti, Cr, Sn enthält,
**dadurch gekennzeichnet,**
**dass** der Leuchtstoff (5) zusätzlich Fluor in einem Anteil von 1-25 % at im Verhältnis zum Gesamtgehalt von Stickstoff, Sauerstoff und Fluor im Oxonitrid-α-Sialonmaterial enthält.

## Claims

1. A semiconductor source for white light, which has a semiconductor radiation crystal (I) on the basis of a multi-element system of Al-In-Ga-N, which generates light in the blue-violet spectral range, and a coating which contains a luminescent substance (5) that absorbs a portion of the light emitted by the crystal (1) and emits light in the yellow spectral range, and α-sialon material activated by divalent europium is used as the luminescent substance (5), and the luminescent substance (5) additionally contains one or more elements selected from the group comprising Ce, Pr, Nd, Sm, Gd, Tb, Dy, Ho, Er, Tm, Yb, Mn, Ti, Cr, and Sn,
**characterized in that**
the luminescent substance (5) additionally contains fluorine in a proportion of 1-25% at in proportion to the total content of nitrogen, oxygen and fluorine in the oxynitride-α-sialon material.

## Revendications

1. Source semi-conductrice de lumière blanche qui présente un cristal rayonnant semiconducteur (1) sur la base d'un système multiéléments Al-In-Ga-N, qui génère de la lumière dans le domaine spectral violet-bleu, et un revêtement qui contient une substance luminescente (5) qui absorbe une partie de la lumière rayonnée par le cristal (1) et émet de la lumière dans le domaine spectral jaune, un matériau a-sialon activé par de l'europium bivalent étant utilisé comme substance luminescente (5) et la substance luminescente (5) contenant de plus un élément ou plusieurs éléments parmi le groupe Ce, Pr, Nd, Sm, Gd, Tb, Dy, Ho, Er, Tm, Yb, Mn, Ti, Cr, Sn,
**caractérisé en ce**
**que** la substance luminescente (5) contient de plus du fluor dans une proportion de 1 à 25 % at par rapport à la teneur totale en axone, oxygène et fluor dans le matériau oxynitrure d'α-sialon.
